# EUROPEAN PATENT APPLICATION

(11) **EP 0 926 505 A1**
(43) Date of publication of application: **30.06.1999**
(21) Application number: 97204117.2
(22) Date of filing: 27.12.1997
(51) Int. Cl.: G01R 31/316, G01R 31/28

(54) **A device with removable configuration boards for testing integrated circuits**

(71) Applicant: Engeli, Franco, 6503 Bellinzona (CH)
(72) Inventor: Engeli, Franco, 6503 Bellinzona (CH)
(74) Representative: Perani, Aurelio

(57) **Abstract**

A device (100) for performing electrical and environmental tests on integrated circuits comprises a first electronic board (105) on which means (110) for the releasable mounting of the integrated circuits are disposed, circuit means for simulating a working condition of the integrated circuits, at least one second electronic board (115) on which the simulation means are disposed, and means (210, 225, 230, 235) for mechanically and electrically connecting each second board (115) to the first board (105) in a releasable manner.

## Description

The present invention relates to a device for performing electrical and environmental tests on integrated circuits and, in particular, to a device according to the preamble to the first claim.

Upon completion of their manufacture, integrated circuits are generally subjected to a test procedure for checking their parameters and applying a series of electrical and environmental stresses to the integrated circuits in order to eliminate circuits which have readily identifiable faults or which are potentially faulty. Typically, the integrated circuits are subjected to a heat test known as a "burn-in" which consists of the operation of the integrated circuits for a few tens of hours at high temperature (for example, between -50° and +300°) so as to simulate a long period of operation of the circuits at ambient temperature (25°-50°).

The integrated circuits to be tested (the devices under test, or DUTs) are housed on a suitable device constituted by an electronic test board (called a burn-in board or BIB) on which there are circuit elements which simulate a working condition of the integrated circuits and enable the test board to be interfaced with a driver. The test board, which is formed on an insulating substrate typically 1.2 mm thick, is supported by a metal frame which facilitates its use and at the same time prevents any damage to the electronic components disposed thereon.

A disadvantage of known test devices is that each one is usable exclusively for integrated circuits of a specific type for which the test device has been designed and produced. This necessitates the manufacture of a different test device when any characteristic of the integrated circuit to be tested is changed, even if the change is very small. The cost of the test procedure is consequently very high and cannot be absorbed in the short term; this drawback limits the use of the test procedure and does not permit its extensive application, consequently reducing the level of quality and reliability in the production of integrated circuits.

The object of the present invention is to overcome the aforementioned drawbacks. To achieve this object, a device for performing electrical and environmental tests on integrated circuits as described in the first claim is proposed.

Further characteristics and the advantages of the device according to the present invention will become clear from the following description of a preferred embodiment thereof, given by way of non-limiting example with reference to the appended drawings, in which:
Figures 1a and 1b are a schematic plan view and a schematic front view of a test device according to the present invention, respectively,
Figure 2 shows, in section, an embodiment of the connection of a configuration board to the base board of the test device of Figure 1,
Figure 3 shows schematically an oven in which the test device can be used.

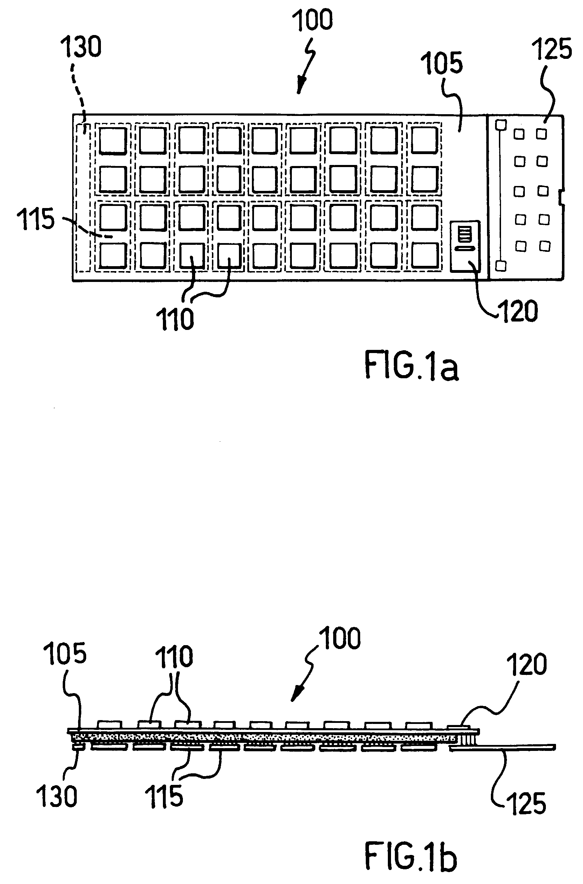

With reference in particular to Figures 1a and 1b (elements common to the two drawings are identified by the same reference numerals), these show a device 100 for testing integrated circuits (not shown in the drawings); the device 100 is preferably used for performing heat tests, although its use for electrical and environmental tests of other types, for example, pressure or humidity tests or the like, is not excluded. The integrated circuits to be tested are typically formed in chips of semiconductor material which are then encapsulated in suitable containers (packages) constituted by insulating bodies (for example, plastics or ceramic bodies) from which the terminal conductors (leads) project, facing downwardly for connection to an external circuit; alternatively, the integrated circuits are of the surface-mounted type (with the terminals bent horizontally), of the ball-grid array (BGA) type, of the type without a package for mounting directly with the chip inverted (flip-chip), etc.

The test device 100 includes a printed-circuit base board (or PCB) 105 constituted by an insulating substrate on which conductive metal tracks are arranged. On an upper surface of the base board 105 there are connection sockets 110 for the integrated circuits to be tested. In the embodiment shown, there are 36 connection sockets 110 arranged in 9 columns; the present invention may, however, be implemented with any number of connection sockets. Each connection socket 110 typically comprises a series of metallized holes in which the terminals of the integrated circuit are fitted, the circuit being kept in position by means of a suitable clip; this structure enables the integrated circuit to be mounted for the time necessary to perform the test and, at the same time, allows the integrated circuit to be removed upon completion of the test procedure without being damaged. Alternatively, resilient conductive pads, on which the conductive balls of BGA integrated circuits bear, or other equivalent means, are used for the releasable mounting of the integrated circuits.

The connection sockets 110 are preferably soldered to the base board 105. This ensures that the positions of the connection sockets 110 on the base board 105 can be determined extremely precisely relative, for example, to suitable mechanical references such as through-holes (not shown in the drawing) in the corners of the base board 105. This feature enables the integrated circuits to be mounted on and removed from the connection sockets 110 by automatic loading/unloading methods; any errors in the positioning of the connection sockets 110 are in fact of limited magnitude and in any case are fully compensated by the tolerance of the connection sockets 110 themselves.

In the test device 100 according to the present invention, there are also one or more configuration boards 115 on which there are circuit elements (for example, passive electronic components such as resistors, diodes and the like) which simulate a working condition of the integrated circuits to be tested. The configuration boards 115 are mechanically and electrically connected to the base board 105 in a releasable manner (as described in detail below).

The investment costs of the test procedures arc thus drastically reduced; in fact, the same base board 105 (which is quite expensive) can be used for testing integrated circuits of various types having connection terminals of similar structure (compatible with the same connection sockets 110), simply by replacement of the configuration boards 115. This solution reduces the waiting times for the production of a test device. In fact, the base board 105, which requires a considerable production time, can be re-used if it is already available for testing other integrated circuits; in this case, it suffices to produce configuration boards 115 specific to the test procedure, which require a very short production time. Moreover, if there are problems with the configuration boards 115, they can be replaced by spare boards at low cost and without interruption of the test procedure; it should be noted that, in this case, it suffices to keep in stock only the configuration boards (and not the base board) with a consequent reduction in storage cost.

The configuration boards 115 face the base board 105 and are connected to a lower surface thereof. More space is thus available for the connection sockets 110 for a given size of test device 100, so that the test device 100 can hold a larger number of integrated circuits. This results in a lower cost of the test device 100 per integrated circuit tested. For a given overall number of integrated circuits tested, this structure also involves less handling of the test device 100 and hence a lower risk of breakage thereof. Alternatively, the configuration boards are arranged differently, for example, they are connected to the upper surface of the base board, or beside the base board.

In the preferred embodiment shown in the drawings, there are 18 configuration boards 115, each of which is associated with 2 connection sockets 110. The configuration boards 115 (which are of small dimensions) are thus easy to handle and can be connected to and disconnected from the base board 105 easily and quickly. Alternatively, the present invention is implemented with a different number of configuration boards (or even with only one configuration board).

A supply configuration board 120 (or another equivalent circuit element), disposed on the upper surface of the base board 105, enables the supply voltage supplied to the integrated circuits mounted in the connection sockets 110 to be varied selectively (for example, by means of suitable switches); the same test device 100 can thus be used for integrated circuits which require different supply voltages. The present invention may, however, also be implemented with a fixed voltage supply.

In a particularly advantageous embodiment of the present invention, an interface board 125 is connected to the lower surface of the base board 105 so as to project beyond a right-hand edge thereof; the interface board 125 is used (as described in detail below) for connecting the test device 100 to a driver The interface board 125 enables the test device 100 to be adapted to various drivers, possibly even from different manufacturers; moreover, the interface board 125 is removable so that it can be replaced in the event of damage (typically due to a breakage in the region of the connection to the driver). An end board 130 (connected to the lower surface of the base board 105 in the region of a left-hand edge thereof) is preferably also provided and operates as an electrical adaptor so as to reduce interference (due, for example, to reflection phenomena) present in the electrical signals generated during the test procedure.

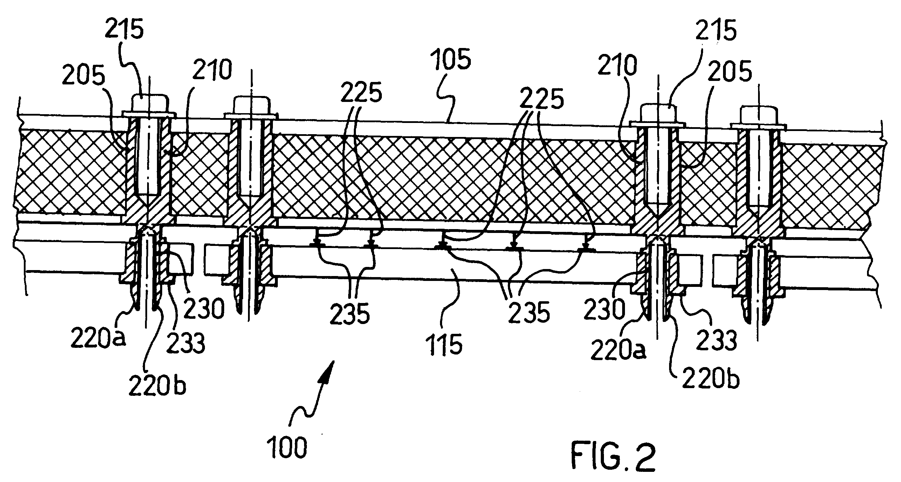

With reference now to Figure 2 (the elements already shown in Figure 1 are identified by the same reference numerals), through-holes 205 with diameters of a few mm (four holes are shown in the drawing) are formed in the base board 105. Each through-hole 205 houses a fixing pin 210 made, for example, of spring steel. The pin 210 is fitted in the through-hole 205 from below until a collar on the pin 210 abuts a corresponding shoulder formed by a lower enlargement of the through-hole 205; the pin 210 is then fixed to the base board 105 by means of a screw 215 (with a corresponding washer) screwed into a threaded hole formed in the free upper end of the pin 210 and arranged along a longitudinal axis thereof. In a lower portion of the pin 210 which extends perpendicularly downwards from the lower surface of the base board 105, there is a slot defining two parallel tabs 220a, 220b which are resiliently deformable transversely relative to the longitudinal axis of the pin 210; each tab 220a, 220b has at its end a head shaped so as to define a rear lead-in face and a front stop face.

Conductor pins 225 (made, for example, of copper, nickel or beryllium and then gold-plated), electrically connected to the connection sockets of the base board 105, also extend perpendicularly downwards from the lower surface of the base board 105. Each conductor pin 225 has a resilient telescopic structure and is shortened by the action of an external force in opposition to an internal spring.

In each configuration board 115 there are through-holes 230 corresponding to the pins 210; a centring bush 233 made, for example, of bronze, is advantageously inserted in each through-hole 210. In a preferred embodiment of the present invention, 6 through-holes 320 are formed in an asymmetric arrangement, for example, along an outer edge of each configuration board 115. Conductive pads 235 (made, for example, of gold-plated copper), corresponding to the conductor pins 225 and electrically connected to the simulation circuit elements, are arranged on an upper surface of the configuration board 115 facing the base board 105; the number of pads 235 on each configuration board is variable and is generally of the order of a few hundreds.

The test device 100 is assembled by the snap engagement of each configuration board 115 onto the base board 105. In particular, the through-holes 230 are placed against the corresponding pins 210 and the configuration board 115 is pushed with force against the base board 105. The rear lead-in faces of the tabs 220a, 220b come into contact with the centering bushes 233 so that this force causes the tabs 220a, 220b to yield resiliently. When the heads of the tabs 220a, 220b emerge from the through-holes 230, the tabs 220a, 220b return to their original rest position so that the configuration board 115 is mechanically connected to the base board 105 by virtue of the interference of the front stop faces of the tabs 220a, 220b with the centering bushes 233.

In a different embodiment of the present invention, safety screws (not shown in the drawing) are also provided and are inserted in threads formed in the tabs 220a, 220b; this prevents any accidental release of the configuration board 115 (as a result, for example, of a deterioration in the resilience properties of the pins 210) and is particularly advantageous when infrequent connection/ disconnection operations are envisaged.

At the same time, the pads 235 bear against the conductor pins 225 causing them to yield resiliently; when the configuration board 115 is connected to the base board 105, each conductor pin 225 is kept urged against the corresponding pad 235 so as to ensure a rigid mechanical connection and a good electrical connection of the configuration board 115 to the base board 105. The unit thus produced is therefore ready for use in order to carry out test operations (as described in detail below) on the integrated circuits fitted on the base board 105 at the time in question.

The configuration board 115 can easily be disconnected from the base board 105 simply by the movement of the heads of the tabs 220a and 220b towards one another (manually or by means of a suitable tool) so as to disengage rear stop faces of the tabs from the centering bushes 233; at this point, the configuration board 115 is free to be removed from the base board 105.

The structure described above enables the configuration boards 115 to be connected to and disconnected from the base board 105 extremely easily and quickly. The connection system (mechanical and electrical) thus formed is very strong and ensures prolonged use without malfunction. Moreover, the solution used to fix the pins 210 to the base board 105 requires the base board 105 to be quite thick, for example, between 0.5cm and 1.5cm thick; the base board 105 thus also performs the function of a rigid support so that the test device does not require a mechanical frame. The present invention may, however, also be formed with a bayonet connection, a transverse-pin connection, a resilient-block connection, or other equivalent connection means.

It should be noted that the number of through-holes 230 (and of corresponding pins 210) provided for each configuration board 115 enables the configuration board 115 to be connected to and disconnected from the base board 105 without requiring the use of excessive force in order to deform the tabs 220a, 220b; in particular, these operations may even be performed by a single operator. At the same time, this solution ensures a sufficiently rigid connection between the configuration board 115 and the base board 105. Moreover, the asymmetric arrangement of the through-holes 230 allows the configuration board to be connected to the base board 105 only in the correct position in which the various conductor pins 225 are facing the corresponding pads 235, preventing the configuration board 115 from being connected the wrong way round (for example, turned through 180°). Alternatively, a different number of through-holes (or even only one through-hole) is provided in each configuration board.

The structure described above also enables the configuration boards 115 to be connected to and disconnected from the base board 105 automatically with the use, for example, of a simple press. At the assembly stage, the press simply urges each configuration board against the base board (until they snap-engage as described above). At the disconnection stage, the press is equipped with operating holes (for example, cylindrical or V-shaped holes, or the like) in the region of each pin 210. When the press is urged against the pins 210, the heads of the tabs 220a and 220b are moved towards one another by the operating holes so that their rear stop faces are released from the centering bushes 233. The resilient force exerted by the conductor pins 225 then removes the configuration board 115 from the base board 105 automatically.

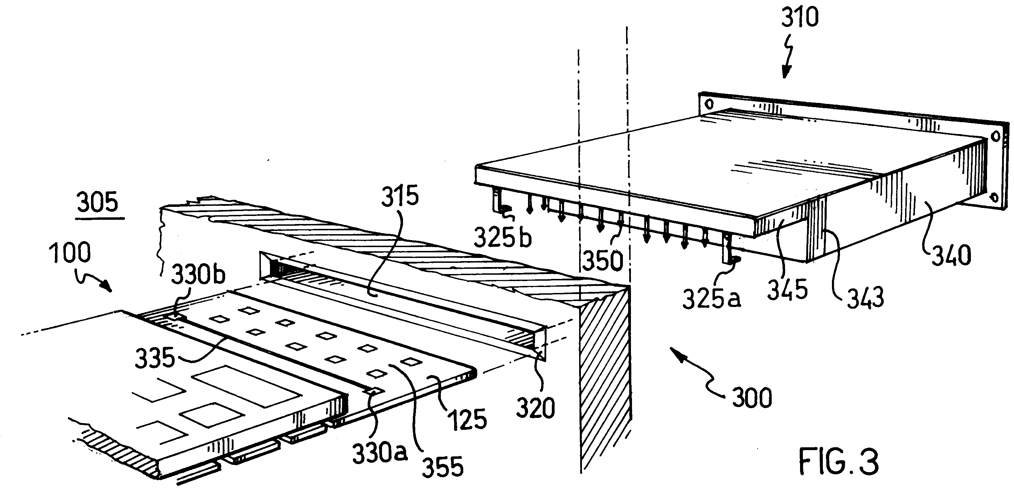

With reference now to Figure 3 (the elements already shown in Figure 1 are identified by the same reference numerals), this shows a heating chamber (an oven) 300 in which the test device 100 described above can be used. The oven 300 is composed of a high-temperature region 305 in which the test devices 100 are positioned and an ambient-temperature region in which an electronic driver 310 which performs operations to control the integrated circuits is disposed.

The test device 100 is connected to the driver 310 through a slot 315 preferably having a seal 320 for insulating the driver 310 from the high-temperature region 305 of the oven. The driver 310 has two sliding conductive tabs 325a and 325b; when the interface board 125 of the test device 100 is fully fitted (up to its travel-limit) in the driver 310, the sliding tabs 325a, 325b come into contact with corresponding conductive pads 330a, 330b disposed on the interface board 125 and connected to one another by means of a conductive track 335.

The sliding tabs 325a, 325b are connected to a control unit 340 formed, for example, by a microprocessor, which can detect the travel-limit position of the interface board 125. For example, the sliding tabs 325a, 325b are connected, respectively, to a reference terminal (earth) and to a positive terminal of a supply (the negative terminal of which is connected to the earth terminal); when the interface board 125 is fully fitted in the driver 310, the sliding tabs 325a, 325b are electrically connected to one another by means of the pads 330a, 330b and the track 335. The travel-limit position of the interface board 125 is thus identified simply by measurement of the current through the sliding tabs 325a, 325b. Alternatively, optical or mechanical systems or other equivalent means which can detect a position in which the interface board 125 is fitted in the driver 310 are used.

When the control unit 340 detects the travel-limit position of the interface board 125, this unit activates a mechanical actuator 343 which brings about downward movement of a plate 345 on which resilient conductor pins 350 (similar to the pins 225 of Figure 2) are disposed; the resilient pins 350 thus come into contact with corresponding conductive pads 355 formed on an upper surface of the interface board 125 so as to establish an electrical connection between the test device 100 and the driver 310. Similar remarks apply if the conductive pads are formed on a lower surface of the interface board 125 or on both lower and upper surfaces. Upon completion of the test procedure, it suffices to repeat the operations described above in reverse order so as to remove the interface board 125 from the driver 310.

This structure offers the advantage that it requires an extremely limited force to fit the interface board 125 in the driver 310, enabling this operation to be performed automatically. Similar remarks apply to equivalent devices used to perform tests of other types (humidity tests, pressure tests and the like); moreover, it should be noted that the driver described above may also be used with different test devices, for example, without the interface board or with a fixed interface board, without configuration boards (with the simulation circuits disposed directly on the base board), etc.

Naturally, in order to satisfy contingent and specific requirements, an expert in the art may apply to the above-described device for performing electrical and environmental tests on integrated circuits many modifications and variations all of which, however, are included in the scope of protection of the invention as defined by the following claims.

## Claims

1. A device (100) for performing electrical and environmental tests on integrated circuits, comprising a first electronic board (105) on which there are means (110) for the releasable mounting of the integrated circuits, and circuit means for simulating a working condition of the integrated circuits,
characterized in that
it includes at least one second electronic board (115) on which the simulation means are disposed, and means (210, 225, 230, 235) for mechanically and electrically connecting each of the second boards (115) releasably to the first board (105).

2. A device (100) according to Claim 1, in which the mounting means include a plurality of connection sockets (110) soldered to the first board (105).

3. A device (100) according to Claim 1 or Claim 2, in which each of the boards (115) faces the first board (105).

4. A device (100) according to Claim 3, in which each second board (115) is associated with two connection sockets (110).

5. A device (100) according to any one of Claims 1 to 4, in which the connection means (210, 225, 230, 235) include at least one snap element (210, 230) for mechanically connecting the second board (115) to the first board (105).

6. A device (100) according to Claim 5, in which each snap element (210, 230) includes a pin (210) fixed to the first board (105) and extending perpendicularly from a surface thereof which faces the second board (115), the pin (210) being snap-engaged in a corresponding through-hole (230) formed in the second board (115).

7. A device (100) according to Claim 6, in which the pin (210) includes two tabs (220a, 220b) which can be deformed transversely relative to a longitudinal axis of the pin (210), each tab (220a, 220b) having at its end a front lead-in face and a rear stop face for cooperating with the hole (230).

8. A device (100) according to Claim 6 or Claim 7, in which 6 through-holes (230) are formed in each second board (115).

9. A device (100) according to any one of Claims 6 to 8, in which the through-holes (230) are arranged asymmetrically on each second board (115).

10. A device (100) according to any one of Claims 6 to 9, in which the first board (105) is formed on an insulating substrate having a thickness of between 0.5cm and 1.5cm.

11. A device (100) according to any one of Claims 1 to 10, in which the connection means (210, 225, 230, 235) include a plurality of conductor pins (225) of resilient telescopic structure, each conductor pin (225) being kept urged against a corresponding conductive pad (235) formed on the second board (115) in order to connect the second board (115) electrically to the first board (105).

12. A device (100) according to any one of Claims 1 to 11, further comprising means (120) for selectively varying the value of a supply voltage of the integrated circuits.

13. A device (100) according to any one of Claims 1 to 12, further comprising an interface board (125) for connecting the test device (100) to a driver (310), the interface board (125) being connected releasably to the first board (105).

14. An electronic board (105) comprising means (110) for the mounting of integrated circuits, for use in the test device (100) according to any one of Claims 1 to 13.

15. An electronic board (115) comprising circuit means for simulating a working condition of integrated circuits for use in the test device (100) according to any one of Claims 1 to 13.

16. A method of performing electrical and environmental tests on integrated circuits comprising the steps of:
mechanically and electrically connecting, in a releasable manner, to a first electronic board (105) on which there are means (110) for the releasable mounting of the integrated circuits, at least one second electronic board (115) on which there are circuit means for simulating a working condition of the integrated circuits,
mounting the integrated circuits on the first electronic board (105).
